# EUROPÄISCHE PATENTSCHRIFT

(11) **EP 3 376 839 B1**
(45) Veröffentlichungstag und Bekanntmachung des Hinweises auf die Patenterteilung: **07.06.2023**
(21) Anmeldenummer: 18159991.1
(22) Anmeldetag: 05.03.2018
(51) Int. Cl.: H05K 7/20

(54) **KÜHLVORRICHTUNG FÜR ELEKTRONISCHES STEUERGERÄT**
COOLING DEVICE FOR ELECTRONIC CONTROL DEVICE
DISPOSITIF DE REFROIDISSEMENT POUR APPAREIL DE COMMANDE ÉLECTRONIQUE

(30) Priorität: 17.03.2017 DE 102017002601
(43) Veröffentlichungstag der Anmeldung: 19.09.2018
(73) Patentinhaber: MAN Truck & Bus SE, 80995 München (DE)
(72) Erfinder: Zaindl, Albert, 85302 Gerolsbach (DE); Brand, Christian, 86576 Schiltberg (DE); Pelzer, Philipp, 82362 Weilheim (DE); Thoma, Lenz, 81737 München (DE)
(74) Vertreter: v. Bezold & Partner Patentanwälte - PartG mbB

(56) Entgegenhaltungen:
- DE-A1- 10 102 869
- DE-U1-202005 009 039
- DE-U1-202014 104 445
- US-A1- 2007 230 184

## Beschreibung

Die Erfindung betrifft ein elektronisches Steuergerät, ein Kraftfahrzeug mit einem elektronischen Steuergerät und ein Verfahren zum Kühlen eines elektronischen Steuergeräts.

Leistungsbauteile, wie beispielsweise Grafikprozessoren, von elektronischen Steuergeräten können während des Betriebs sehr heiß werden. Zusätzlich können elektronische Steuergerät in einem Kraftfahrzeug teilweise sehr hohen Temperaturen ausgesetzt sein, wenn sie beispielsweise dicht an einem Getriebe oder einem Verbrennungsmotor angeordnet sind. Um einen Ausfall des elektronischen Steuergeräts aufgrund einer Überhitzung zu verhindern und eine Lebensdauer zu verlängern, kann das Steuergerät gekühlt werden.

Die Kühlung kann beispielsweise passiv durch Konvektion oder unterstützt durch Lüfter durchgeführt werden. Um Wärme an die Umgebung abzugeben, müssen Steuergeräte große Oberflächen aufweisen. Die Wärme kann dabei nur in einem geringen Maß in Abhängigkeit von der Umgebungstemperatur abgegeben werden. Zusätzlich kann sich bildende Stauluft die Wärmeabgabe weiter verringern.

Die DE 195 17 491 A1 offenbart eine Kühlung für eine Getriebesteuereinrichtung eines Kraftfahrzeugs. Eine Steuerelektronik der Steuereinrichtung wird durch gezielte Zuführung eines Steuerfluids an die Steuerelektronik oder durch die Steuerelektronik zwangsgekühlt. Das Steuerfluid kann durch Fördermittel durch eine Kühlplatte getrieben werden, auf der die Steuerelektronik mit optimaler Wärmeleitfähigkeit angeordnet ist. Das Steuerfluid kann Luft oder Hydrauliköl sein.

Die DE 20 2005 009 039 U1 offenbart ein elektronisches Steuergerät für ein Kraftfahrzeug, insbesondere für eine Getriebesteuerung. Das elektronische Steuergerät weist eine in einem Gehäuse angeordnete Leiterplatte, die elektronische Bauelemente trägt, auf. Zwischen der Leiterplatte und dem Gehäuse ist eine Elektronikwärmeschutzbarriere angeordnet. Pressluft kann in einer mäanderförmigen Kühlschlange eines Kühlelements des elektronischen Steuergeräts geführt werden.

Die DE 20 2014 104 445 U1 offenbart eine Anordnung mindestens eines elektronischen Steuergeräts in einem Kraftfahrzeug. Ein Schutzgehäuse umfasst einen Aufnahmeraum, innerhalb dessen das mindestens eine elektronische Steuergerät untergebracht ist. Durch einen Luftströmungskanal ist Kühlluft führbar. In mindestens einer der Gehäusewandungen des Schutzgehäuses ist ein Kühlkörper angeordnet, der sich abschnittsweise nach außen in den Luftströmungskanal erstreckt und mit der Kühlluft beaufschlagbar ist.

Die DE 101 02 869 A1 offenbart eine Vorrichtung und ein Verfahren zur Kühlung von temperaturkritischen Bauteilen, insbesondere elektronischen Bauteilen auf Leiterplatinen, wobei ein Mittel zur Zufuhr eines komprimierten Kühlmittels an das zu kühlende Bauteil und ein Mittel zur Dekompression des Kühlmittels vorgesehen sind, sodass durch die Ausdehnungsarbeit des Kühlmittels die Kühlung unterstützt wird.

Der Erfindung liegt die Aufgabe zu Grunde, eine verbesserte Kühlung für ein elektronisches Steuergerät eines Kraftfahrzeugs vorzusehen.

Die Aufgabe wird gelöst durch ein elektronisches Steuergerät für ein Kraftfahrzeug und ein Verfahren zum Kühlen eines elektronischen Steuergeräts gemäß den unabhängigen Ansprüchen. Vorteilhafte Weiterbildungen sind in den abhängigen Ansprüchen und der Beschreibung angegeben.

Das elektronische Steuergerät weist eine erste Steuerelektronik, insbesondere eine erste bestückte Platine, auf. Das elektronische Steuergerät weist einen Gaskühlkanal zum Führen eines verdichteten Gases auf. Der Gaskühlkanal ist mit der ersten Steuerelektronik wärmeleitend verbunden und zum Trennen des verdichteten Gases von der ersten Steuerelektronik ausgebildet. Der Gaskühlkanal weist einen Entspannungsabschnitt auf. In dem Entspannungsabschnitt erweitert sich ein Strömungsquerschnitt des Gaskühlkanals zum Entspannen und Abkühlen des verdichteten Gases zur Kühlung der ersten Steuerelektronik.

Die erste Steuerelektronik kann somit gezielt durch das sich während der Entspannung abkühlende Gas gekühlt werden. Die Kühlung benötigt keine verschleißanfälligen Bauteile, wie beispielsweise Lüfter. Durch die Trennung des verdichteten Gases von der ersten Steuerelektronik kann verhindert werden, dass Verunreinigungen in dem verdichteten Gas, zum Beispiel Öltropfen oder Staubpartikel, in Kontakt mit der Steuerelektronik kommen.

Der Entspannungsabschnitt kann einen Strömungsquerschnitt des Gaskühlkanals kontinuierlich und/oder stufenförmig erweitern.

Der Entspannungsabschnitt vergrößert den Strömungsquerschnitt des Gaskühlkanals. Eine Fläche eines Strömungsquerschnitts stromabwärts des Entspannungsabschnitts kann beispielsweise größer als 1,5 Mal einer Fläche eines Strömungsquerschnitts stromaufwärts des Entspannungsabschnitts sein. Die Vergrößerung des Strömungsquerschnitts kann bspw. einen Faktor in einem Bereich zwischen 1,5 und 20 aufweisen.

In einer Ausführungsform weist das elektronische Steuergerät ferner eine zweite Steuerelektronik, insbesondere eine zweite bestückte Platine, auf.. Der Gaskühlkanal ist insbesondere zwischen der ersten Steuerelektronik und der zweiten Steuerelektronik angeordnet. Dies hat den Vorteil, dass eine Kühlung durch den Gaskühlkanal zweiseitig erfolgen kann.

In einer vorteilhaften Weiterbildung weist das elektronische Steuergerät ferner ein Gehäuse auf und die erste Steuerelektronik, die zweite Steuerelektronik und/oder der Gaskühlkanal ist in dem Gehäuse angeordnet ist. Alternativ oder zusätzlich ist der Gaskühlkanal in einer Kühlplatte oder Kühlschlange integriert, die mit der ersten Steuerelektronik, der zweiten Steuerelektronik und/oder einem Gehäuse des elektronischen Steuergeräts zusammenmontiert (z. B. aneinander angebracht oder aufgesetzt) ist. In dem Gehäuse kann die erste Steuerelektronik und/oder die zweite Steuerelektronik angeordnet sein.

In einer weiteren Ausführungsform weist die erste Steuerelektronik und/oder die zweite Steuerelektronik ein Leistungsbauteil auf. Das Leistungsbauteil kann insbesondere ein Prozessor, ein Grafikprozessor, eine Netzwerkschnittstelle, ein Mikrocontroller und/oder eine Speichereinheit sein. Das Leistungsbauteil ist wärmeleitend mit dem Gaskühlkanal, insbesondere dem Entspannungsabschnitt und/oder einem Abschnitt stromabwärts des Entspannungsabschnitts, verbunden. Folglich kann ein Leistungsbauteil gezielt gekühlt werden.

In einer weiteren Ausführungsvariante ist der Gaskühlkanal auf die erste Steuerelektronik aufgesetzt ist und/oder die zweite Steuerelektronik ist auf den Gaskühlkanal aufgesetzt. Dies ermöglicht eine kompakte Sandwichbauweise des elektronischen Steuergeräts.

In einem Ausführungsbeispiel weist die erste Steuerelektronik und/oder die zweite Steuerelektronik eine Leiterplatte auf. Die Leiterplatte ist auf einer Seite, die dem Gaskühlkanal zugewandt ist, mit dem Leistungsbauteil bestückt. Mit anderen Worten gesagt, ist eine Bestückungsseite der Leiterplatte dem Gaskühlkanal zugewandt. Das Leistungsbauteil ragt somit in einer Richtung zu dem Gaskühlkanal. Dadurch kann ein Abstand zwischen dem Leistungsbauteil und dem Gaskühlkanal verringert werden.

Die Leiterplatte kann beispielsweise einseitig oder zweiseitig bestückbar sein.

In einem weiteren Ausführungsbeispiel sind ein Einlass des Gaskühlkanals und ein Auslass des Gaskühlkanals auf der gleichen Seite des Gehäuses angeordnet. Alternativ oder zusätzlich weist der Gaskühlkanal mindestens eine Umlenkung um 180° auf. Dies ermöglicht einen langen Gaskühlkanal, wodurch die Kühlleistung gesteigert werden kann.

Vorzugsweise ist der Gaskühlkanal zum Führen von Druckluft ausgebildet. Alternativ oder zusätzlich ist der Gaskühlkanal mit einem Drucktank, insbesondere einem Drucklufttank, verbunden oder verbindbar. Die Verwendung von Druckluft kann insbesondere dann vorteilhaft sein, wenn bereits ein Druckluftsystem vorhanden ist. Dies kann beispielsweise bei Nutzfahrzeugen der Fall sein.

In einem weiteren Ausführungsbeispiel weist das elektronische Steuergerät ferner einen Kühlkörper auf. Der Kühlkörper ist in dem Gaskühlkanal, insbesondere in dem Entspannungsabschnitt und/oder einem Abschnitt stromabwärts des Entspannungsabschnitts angeordnet. Der Kühlkörper ist wärmeleitend mit der ersten Steuerelektronik und/oder der zweiten Steuerelektronik verbunden. Dies hat den Vorteil, dass der Kühlkörper eine Wärmeleitung zwischen dem abgekühlten Gas und der Steuerelektronik verbessern kann. Der Kühlkörper kann zudem eine große Oberfläche aufweisen. Die Wärmeübertragung zwischen dem abgekühlten Gas und dem Kühlkörper kann somit vergrößert werden.

In einer weiteren Ausführungsform ist der Kühlkörper wärmeleitend mit dem Leistungsbauteil der ersten Steuerelektronik und/oder der zweiten Steuerelektronik verbunden. Alternativ oder zusätzlich weist der Kühlkörper eine Mehrzahl von Kühlrippen, die insbesondere entlang einer Strömungsrichtung im Gaskühlkanal ausgerichtet sind, auf. Das Vorsehen von Kühlrippen kann die Oberfläche des Kühlkörpers vergrößern.

In einer weiteren Ausführungsvariante ist eine Mehrzahl von Kühlkörpern für die erste Steuerelektronik und/oder die zweite Steuerelektronik, insbesondere für eine Mehrzahl von Leistungsbauteilen der ersten Steuerelektronik und/oder der zweiten Steuerelektronik, vorgesehen. Dies hat den Vorteil, dass mehrere elektronische Bauteile gezielt gekühlt werden können.

Ein Kühlkörper kann mit mehreren Leistungsbauteilen wärmeleitend verbunden sein. Zum Beispiel kann ein Kühlkörper mit einem Leistungsbauteil der ersten Steuerelektronik und einem Leistungsbauteil der zweiten Steuerelektronik wärmeleitend verbunden sein. Der Kühlkörper kann beispielsweise zwischen den beiden Leistungsbauteilen angeordnet sein.

Es ist auch möglich, dass für jedes Leistungsbauteil, das eine gezielte Kühlung benötigt, ein eigener Kühlkörper vorgesehen ist.

In einem Ausführungsbeispiel weist der Gaskühlkanal eine Mehrzahl von Entspannungsabschnitten auf, die insbesondere jeweils wärmeleitend mit einem oder mehreren Leistungsbauteilen der ersten Steuerelektronik und/oder der zweiten Steuerelektronik verbunden sind. Die Entspannungsabschnitte können in Reihe und/oder parallel angeordnet sein.

In einer Ausführungsform weist das elektronische Steuergerät ferner ein Gasventil auf. Das Gasventil ist im Gaskühlkanal, insbesondere stromaufwärts des Entspannungsabschnitts, oder stromaufwärts des Gaskühlkanals zum Einstellen einer Strömungsmenge des verdichteten Gases angeordnet. Dies ermöglicht die Steuerung einer Zufuhr des verdichteten Gases und somit eine Steuerung der Kühlleistung.

Das Gasventil kann ein Schaltventil oder ein Stetigventil sein. Das Schaltventil kann ein diskretes Schalten zwischen auf und zu ermöglichen. Das Stetigventil kann einen stetigen Übergang zwischen den Schaltstellungen zulassen, wodurch ein Volumenstrom des verdichteten Gases einstellbar ist.

In einer weiteren Ausführungsvariante weist das elektronische Steuergerät ferner einen Temperatursensor zum Messen einer Temperatur des Leistungsbauteils, der ersten Steuerelektronik, der zweiten Steuerelektronik und/oder des elektronischen Steuergeräts auf. Das Gasventil kann zusätzlich basierend auf einer von dem Temperatursensor gemessen Temperatur gesteuert werden. Dies ermöglicht eine Kontrolle der Temperatur des elektronischen Steuergeräts. Ferner kann das elektronische Steuergerät in einem gewünschten Temperaturbereich durch eine entsprechende Steuerung des Gasventils gehalten werden.

Die Erfindung betrifft ferner ein Kraftfahrzeug, insbesondere ein Nutzfahrzeug, mit einem Drucktank, vorzugsweise einem Drucklufttank, und einem elektronischen Steuergerät wie hierin offenbart. Der Gaskühlkanal des elektronischen Steuergeräts ist mit dem Drucktank verbunden. Das Kraftfahrzeug kann ferner insbesondere einen Motor und einen Verdichter aufweisen. Der Verdichter kann von dem Motor angetrieben werden und mit dem Drucktank verbunden sein. Der Drucktank und der Verdichter können insbesondere Teile eines bestehenden Druckluftsystems des Kraftfahrzeugs sein, das bereits für andere Anwendungen vorgesehen ist.

Die Erfindung betrifft zudem ein Verfahren zum Kühlen eines elektronischen Steuergeräts insbesondere in einem Kraftfahrzeug. Das Verfahren weist das Führen eines verdichteten Gases, insbesondere Druckluft, durch einen Gaskühlkanal auf. Der Gaskühlkanal trennt das verdichtete Gas von einer Steuerelektronik des elektronischen Steuergeräts und ist wärmeleitend mit der Steuerelektronik verbunden. Das Verfahren weist ferner das Entspannen des verdichteten Gases in dem Gaskühlkanal auf. Das Verfahren weist zudem das Abkühlen des Gases durch das Entspannen sowie das Kühlen der Steuerelektronik, insbesondere eines Leistungsbauteils der Steuerelektronik, durch das Abkühlen des Gases auf.

Es versteht sich, dass das Entspannen des verdichteten Gases definiert (gesteuert) gemäß einer vorgegeben Strömungsquerschnittserweiterung erfolgt.

Ebenso wie das hierin offenbarte elektronische Steuergerät ermöglicht das Verfahren die gezielte Kühlung der Steuerelektronik durch das sich während der Entspannung abkühlende Gas. Die gezielte Entspannung des verdichteten Gases in dem Gehäuse ermöglicht die gezielte Kühlung der Steuerelektronik. Die Kühlung benötigt keine verschleißanfälligen Bauteile, wie beispielsweise Ventilatoren.

In einer Variante weist das Verfahren ferner das Verdichten des Gases und das Abkühlen des verdichteten Gases in einem Drucktank, insbesondere einem Drucklufttank, des Kraftfahrzeugs auf. Das abgekühlte verdichtete Gas kann dann zum Kühlen des elektronischen Steuergeräts verwendet werden. Die Abkühlung kann ohne weiteren Aufwand durch den Einfluss der Umgebungstemperatur auf den Drucktank erfolgen.

Die zuvor beschriebenen bevorzugten Ausführungsformen und Merkmale der Erfindung sind beliebig miteinander kombinierbar. Weitere Einzelheiten und Vorteile der Erfindung werden im Folgenden unter Bezug auf die beigefügten Zeichnungen beschrieben. Es zeigen:
- Figur 1: eine beispielhafte Anordnung mit einem Steuergerät;
- Figur 2: eine schematische Schnittdarstellung durch ein beispielhaftes Steuergerät entlang der Linie B-B in Figur 3;
- Figur 3: einen andere schematische Schnittdarstellung durch das beispielhafte Steuergerät entlang der Linie A-A in Figur 2;
- Figur 4: eine Schnittdarstellung gemäß der Figur 3 für ein anderes beispielhaftes Steuergerät.

Die in den Figuren gezeigten Ausführungsformen stimmen zumindest teilweise überein, so dass ähnliche oder identische Teile mit den gleichen Bezugszeichen versehen sind und zu deren Erläuterung auch auf die Beschreibung der anderen Ausführungsformen bzw. Figuren verwiesen wird, um Wiederholungen zu vermeiden.

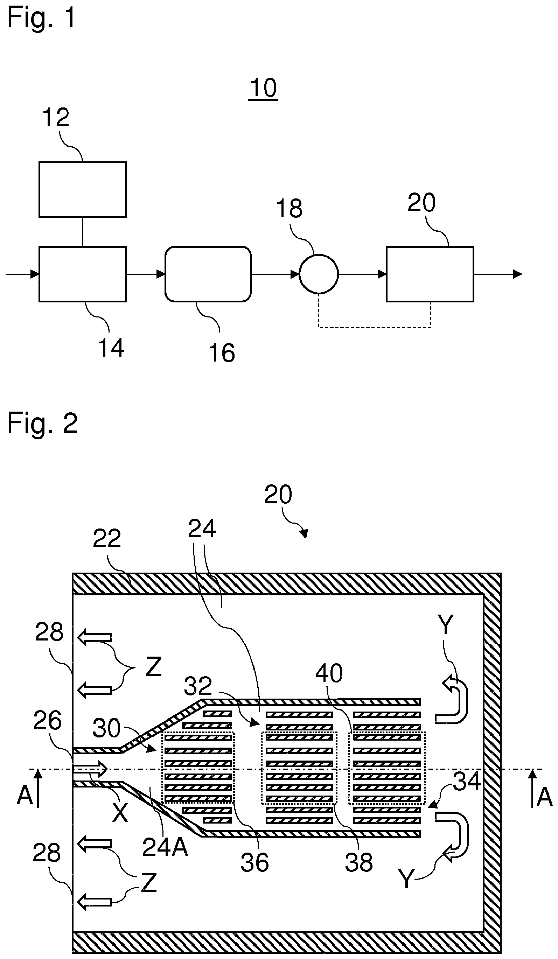

In Figur 1 ist eine Anordnung 10 dargestellt. Die Anordnung 10 weist einen Motor 12, einen Verdichter 14, einen Drucktank 16, ein Gasventil 18 und ein elektronisches Steuergerät 20 auf. Die Anordnung 10 kann beispielsweise in einem Kraftfahrzeug, insbesondere einem Nutzfahrzeug, zum Beispiel einem Lastkraftwagen oder einem Omnibus, vorgesehen sein.

Nachfolgend ist eine Ausführungsform bei der Druckluft als verdichtetes Gas zum Kühlen des Steuergeräts verwendet wird. Andere Ausführungsformen können andere verdichtete Gase verwenden.

Der Motor 12 treibt den Verdichter 14 zum Verdichten von Umgebungsluft an. Der Motor 12 kann ein Elektromotor oder ein Verbrennungsmotor sein. Beim Verdichten erwärmt sich die Umgebungsluft. Die Druckluft wird in dem Drucktank 16 zwischengespeichert, zum Beispiel bei einem Druck von 8 bar. Die Druckluft kühlt in dem Drucktank 16 ab. Die Druckluft in dem Drucktank 16 kann für verschiedene Anwendungen verwendet werden.

Die Druckluft aus dem Drucktank 16 kann über das Gasventil 18 zu dem elektronischen Steuergerät 20 geleitet werden. Das elektronische Steuergerät 20 kann das Gasventil 18 zum Öffnen oder Schließen ansteuern. In einigen Ausführungsformen kann das Gasventil 18 ein steuerbares Gasventil sein, das stufenlos verstellbar ist zwischen einer Öffnungsstellung und einer Schließstellung. Das Gasventil 18 ermöglicht die Einstellung einer Strömungsmenge von Druckluft aus dem Drucktank 16 zu dem elektronischen Steuergerät 20.

Das Gasventil 18 kann in einem Gaskühlkanal des elektronischen Steuergeräts 20, insbesondere stromaufwärts eines Entspannungsabschnitts des Gaskühlkanals, oder stromaufwärts des Gaskühlkanals angeordnet sein.

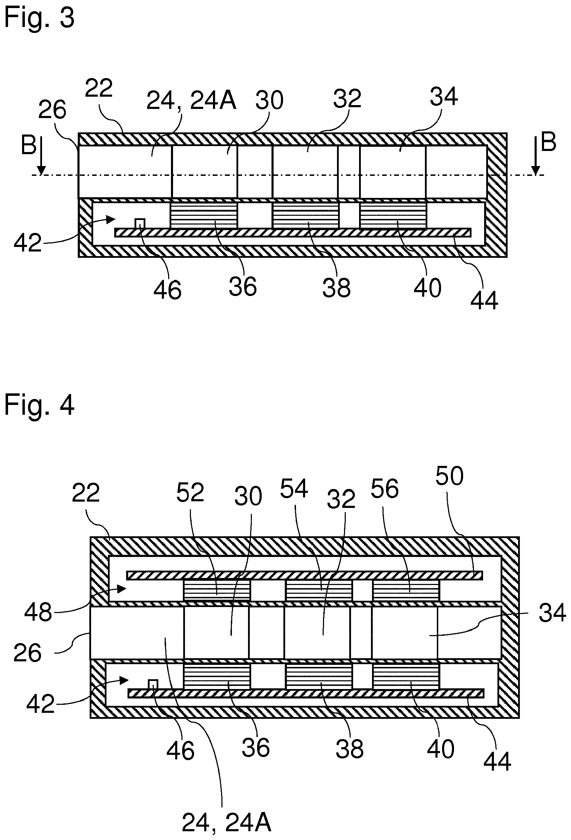

Die Figur 2 zeigt einen Schnitt durch einen Gaskühlkanal des Steuergeräts 20 gemäß der Linie B-B in Figur 3.

Das Steuergerät 20 weist ein Gehäuse 22 auf. In dem Gehäuse 22 ist ein als Druckluftkanal ausgebildeter Gaskühlkanal 24 angeordnet. Der Gaskühlkanal 24 ist über das Gasventil 18 mit dem Drucktank 16 verbunden (siehe Figur 1). Der Gaskühlkanal 24 erstreckt sich zwischen einem Einlass 26 am Gehäuse 22 und einem Auslass 28 am Gehäuse 22. Bei geöffnetem Gasventil 18 (siehe Figur 1) strömt Druckluft durch den Einlass 26 in den Gaskühlkanal 24 ein, wie durch einen Pfeil X gekennzeichnet ist. Die Druckluft durchströmt einen Entspannungsabschnitt 24A des Gaskühlkanals 24. Schließlich wird die Druckluft im Gaskühlkanal um ungefähr 180° umgelenkt, wie durch Pfeile Y dargestellt ist. Letztlich verlässt die Druckluft das Gehäuse 22 durch den Auslass 28, wie durch Pfeile Z dargestellt ist. Die Druckluft kann aus dem Auslass 28 beispielsweise in die Umgebung abgegeben werden. Der Einlass 26 und der Auslass 28 sind auf der gleichen Seite des Gehäuses 22 angeordnet.

Es versteht sich, dass je nach Anforderung auch andere Strömungsführungen für den Gaskühlkanal verwendet werden können.

Im Entspannungsabschnitt 24A vergrößert sich eine Strömungsquerschnittsfläche des Gaskühlkanals 24. Strömt die Druckluft durch den Entspannungsabschnitt 24A, so verringert sich deren Druck. Dies bewirkt eine Abkühlung der sich entspannenden Druckluft im Entspannungsabschnitt 24A. Die sich abkühlende und abgekühlte Druckluft durchströmt mehrere Kühlkörper 30, 32 und 34, die jeweils eine Mehrzahl von Kühlrippen aufweisen. Der Kühlkörper 30 ragt teilweise in den Entspannungsabschnitt 24A hinein. Die Kühlkörper 32 und 34 sind stromabwärts des Entspannungsabschnitts 24A angeordnet. Die Kühlrippen der Kühlkörper 32, 34 und 36 sind entlang einer Strömungsrichtung im Gaskühlkanal 24 ausgerichtet. Beim Durchströmen der Kühlrippen kühlt die durch die Entspannung abgekühlte Druckluft die Kühlrippen der Kühlkörper 30, 32 und 34. Die Kühlkörper 30, 32 und 34 sind wärmeleitend mit entsprechenden Leistungsbauteilen 36, 38 und 40 verbunden.

Die Leistungsbauteile 36, 38 und 40 sind außerhalb des Gaskühlkanals 24 angeordnet. Dies ist in der Figur 2 durch die nur gepunktet dargestellten Umrisse der Leistungsbauteile 36, 38 und 40 angedeutet. Die Leistungsbauteile 36, 38 und 40 können sich im Betrieb des elektronischen Steuergeräts 20 erwärmen. Die Wärmeabfuhr der Leistungsbauteile 36, 38 und 40 erfolgt über die Kühlkörper 30, 32 und 34.

Die Leistungsbauteile 36, 38 und 40 sind insbesondere diejenigen Bauteile des elektronischen Steuergeräts 20, die sich während des Betriebs des elektronischen Steuergeräts 20 in dem Maße erwärmen können, dass sie eine Kühlung benötigen. Die Leistungsbauteile 36, 38 und 40 können beispielsweise als Prozessor, Grafikprozessor, Mikrocontroller, Netzwerkschnittstelle und/oder Speichereinheit ausgebildet sein.

In einigen Ausführungsformen können mehr oder weniger Leistungsbauteile mit dem Gaskühlkanal 24 wärmeleitend verbunden sein.

In Figur 3 ist beispielhaft gezeigt, wie die Leistungsbauteile 36, 38 und 40 wärmeleitend mit den Kühlkörpern 30, 32 und 34 verbunden sind. In der dargestellten Ausführungsform ist der Gaskühlkanal 24 mit dem Entspannungsabschnitt 24A auf die Leistungsbauteile 36, 38 und 40 aufgesetzt.

Eine bestückte Platine 42 weist eine Leiterplatte 44 und die Leistungsbauteile 36, 38 und 40 auf. Die bestückte Platine 42 ist so angeordnet, dass sich die Leistungsbauteile 36, 38 und 40 von der Leiterplatte 44 in Richtung zu dem Gaskühlkanal 24 erstrecken. Mit anderen Worten gesagt, ist die Leiterplatte 44 auf einer Seite, die dem Gaskühlkanal 24 zugewandt ist, mit den Leistungsbauteilen 36, 38 und 40 bestückt. Eine Kühlung der Kühlkörper 30, 32 und 34 durch die sich entspannende Druckluft bewirkt somit eine Kühlung der Leistungsbauteile 36, 38 und 40.

Der Gaskühlkanal 24 trennt die Druckluft von der bestückten Platine 42. Somit kann verhindert werden, dass die bestückte Platine 42 in Kontakt mit Verunreinigungen in der Druckluft, wie beispielsweise Staubpartikel oder Öltropfen, kommt.

Die Leistungsbauteile 36, 38 und 40 sind insbesondere wärmeleitend mit dem Entspannungsabschnitt 24A oder mit einem Abschnitt des Gaskühlkanals 24 stromabwärts des Entspannungsabschnitt 24A verbunden. Dies ermöglicht, dass die Kühlleistung durch die sich entspannende Druckluft genau dort erzeugt wird, wo sie zum Kühlen der Leistungsbauteile 36, 38 und 40 gebraucht wird.

Die durch die Kühlkörper 30, 32, 34 erwärmte Luft tritt beispielsweise ohne erhöhten Druck durch den Auslass 28 aus dem elektronischen Steuergerät aus. Es versteht sich, dass nicht nur die Leistungsbauteile 36, 38 und 40 gekühlt werden, sondern die gesamte bestückte Platine 42 durch den kühlenden Gaskühlkanal 24.

Das elektronische Steuergerät 20 kann ferner einen Temperatursensor 46 aufweisen. Der Temperatursensor 46 misst eine Temperatur des elektronischen Steuergeräts 20, insbesondere der bestückten Platine 42 und/oder der Leistungsbauteile 36, 38 und 40. Basierend auf einer Temperaturmessung von dem Temperatursensor 46 kann das elektronische Steuergerät 20 das Gasventil 18 (siehe Figur 1) steuern. Zum Beispiel kann das elektronische Steuergerät 20 das Gasventil 18 so steuern, dass eine von dem Temperatursensor 46 gemessene Temperatur zwischen 20°C und 40°C bleibt. Insbesondere kann das Gasventil 18 geöffnet werden, wenn die Temperatur des elektronischen Steuergeräts 20 einen oberen Schwellwert überschreitet. Das Gasventil 18 kann geschlossen werden, wenn die Temperatur des elektronischen Steuergeräts 20 einen unteren Schwellwert unterschreitet. In einigen Ausführungsformen kann zusätzlich oder alternativ eine Strömungsmenge durch das Gasventil 18 stufenlos eingestellt werden. Es ist auch möglich, dass mehrere Temperatursensoren vorgesehen sind.

Die Wärmeleitung zwischen den Kühlkörpern 30, 32 und 34 und den Leistungsbauteilen 36, 38 und 40 kann durch Verwenden von Wärmeleitpaste, Wärmeleitfolien und/oder zusätzlichen Kühlkörpern weiter verbessert werden. Zusätzliche Kühlkörper können insbesondere verwendet werden, um einen Abstand zwischen den Leistungsbauteilen 36, 38 und 40 und dem Gaskühlkanal 24 zu überbrücken. So können beispielsweise unterschiedliche Höhen der Leistungsbauteile 36, 38 und 40 ausgeglichen werden.

Die gezielte Kühlung des elektronischen Steuergeräts 20 ermöglicht, dass das elektronische Steuergerät 20 in einem kühlen Betriebsbereich betrieben werden kann. Somit sind beispielsweise höhere Leistungen und eine höhere Lebensdauer erzielbar. Weiterhin benötigt das vorgeschlagene Kühlsystem keine bewegten Teile, wie beispielsweise Lüfter, die mit der Zeit verschleißen können. Zusätzlich kann das elektronische Steuergerät 20 besonders kompakt ausgeführt werden, da keine großen Oberflächen zur Kühlung durch Konvektion benötigt werden. Ist das elektronische Steuergerät 20 in einer Fahrerkabine eines Kraftfahrzeugs angeordnet, so kann eine ungewünschte Erwärmung der Fahrerkabine verringert oder verhindert werden.

Die Figur 4 zeigt eine weitere Ausführungsform mit zwei bestückten Platinen. Neben der ersten bestückten Platine 42, wie in der zuvor beschriebenen Ausführungsform, ist eine zweite bestückte Platine 48 vorgesehen. Insbesondere ist der Gaskühlkanal 24 auf die erste bestückte Platine 42 aufgesetzt und die zweite bestückte Platine 48 ist auf den Gaskühlkanal 24 aufgesetzt. Die erste bestückte Platine 42 und die zweite bestückte Platine 48 können miteinander verbunden sein.

Die zweite bestückte Platine 48 weist eine Leiterplatte 50 und Leistungsbauteile 52, 54 und 56 auf. Die Leistungsbauteile 52, 54 und 56 erstrecken sich von der Leiterplatte 50 in Richtung zu dem Gaskühlkanal 24. Die Leistungsbauteile 52, 54 und 56 sind wärmeleitend mit den Kühlkörper 30, 32 und 34 verbunden.

Die dargestellte Sandwichbauweise ermöglicht ein besonders kompaktes elektronisches Steuergerät 20, da sowohl eine Oberseite als auch eine Unterseite des Gaskühlkanals 24 zum Kühlen verwendet wird.

In anderen Ausführungsformen kann statt der bestückten Platine 42 und/oder der bestückten Platine 48 eine andere Steuerelektronik vorgesehen sein, die von der sich entspannenden Druckluft gekühlt wird.

In einigen Ausführungsbeispielen kann der Gaskühlkanal 24 in einer Kühlplatte oder Kühlschlange integriert sein, die mit der ersten Steuerelektronik 42, der zweiten Steuerelektronik 48 (falls vorhanden) und/oder dem Gehäuse 22 des elektronischen Steuergeräts 20 zusammenmontiert ist. So kann bspw. eine Kühlplatte oder Kühlschlange mit dem Gaskanal 24 direkt auf die erste Steuerelektronik 42 aufgesetzt oder montiert werden. Die Kühlplatte oder Kühlschlange kann auch außerhalb eines Gehäuses der ersten Steuerelektronik 42 vorgesehen sein.

Fachleute werden erkennen, dass sie hier offenbarte Vorrichtung zum Kühlen des elektronischen Steuergeräts 20 auf einem innovativen Verfahren zum Kühlen eines elektronischen Steuergeräts 20 basiert. Das Verfahren kann bspw. die Anordnung 10 verwenden und ist dementsprechend nachfolgend beispielhaft beschreiben.

Das Verfahren zum Kühlen der ersten und/oder zweiten bestückten Platine 42, 48 weist das Zuführen eines verdichteten Gases, insbesondere Druckluft, in das Gehäuse 22 auf. In dem Gehäuse 22 findet in dem Entspannungsabschnitt 24A eine definierte Expansion des verdichteten Gases statt. Der Entspannungsabschnitt 24A ist wärmeleitend mit der ersten und/oder zweiten bestückten Platine 42, 48 verbunden. Das Gas kühlt durch die Expansion ab. Dadurch wird die erste und/oder die zweite bestückte Platine 42, 48 gekühlt.

Vor dem Zuführen des verdichteten Gases kann das Gas beispielsweise durch den Verdichter 14 (siehe Figur 1) verdichtet werden. Dabei kann sich eine Temperatur des Gases erhöhen. Das verdichtete Gas kann in dem Drucktank 16 abkühlen, bevor es in das Gehäuse 22 des elektronischen Steuergerät 20 zugeführt wird.

Die Erfindung ist nicht auf die vorstehend beschriebenen bevorzugten Ausführungsbeispiele beschränkt. Vielmehr ist eine Vielzahl von Varianten und Abwandlungen möglich, die ebenfalls von dem Erfindungsgedanken Gebrauch machen und deshalb in den Schutzbereich fallen. Insbesondere beansprucht die Erfindung auch Schutz für den Gegenstand und die Merkmale der Unteransprüche unabhängig von den in Bezug genommenen Ansprüchen.

### Bezugszeichenliste

- 10: Anordnung zum Kühlen
- 12: Motor
- 14: Verdichter
- 16: Drucktank
- 18: Gasventil
- 20: Elektronisches Steuergerät
- 22: Gehäuse
- 24: Gaskühlkanal
- 24A: Entspannungsabschnitt
- 26: Einlass
- 28: Auslass
- 30: Kühlkörper
- 32: Kühlkörper
- 34: Kühlkörper
- 36: Leistungsbauteil
- 38: Leistungsbauteil
- 40: Leistungsbauteil
- 42: Erste bestückte Platine (erste Steuerelektronik)
- 44: Leiterplatte
- 46: Temperatursensor
- 48: Zweite bestückte Platine (zweite Steuerelektronik)
- 50: Leiterplatte
- 52: Leistungsbauteil
- 54: Leistungsbauteil
- 56: Leistungsbauteil
- X, Y, Z: Luftströmungsrichtung

## Patentansprüche

1. Elektronisches Steuergerät (20) für ein Kraftfahrzeug, aufweisend:
eine erste Steuerelektronik (42), insbesondere eine erste bestückte Platine; und
ein Gaskühlkanal (24) zum Führen eines verdichteten Gases, wobei der Gaskühlkanal (24):
mit der ersten Steuerelektronik (42) wärmeleitend verbunden ist, und
zum Trennen des verdichteten Gases von der ersten Steuerelektronik (42) ausgebildet ist,
**dadurch gekennzeichnet, dass**
der Gaskühlkanal (24) einen Entspannungsabschnitt (24A) aufweist, in dem sich ein Strömungsquerschnitt des Gaskühlkanals (24) zum Entspannen und Abkühlen des verdichteten Gases zur Kühlung der ersten Steuerelektronik (42) erweitert.

2. Elektronisches Steuergerät (20) nach Anspruch 1, ferner aufweisend eine zweite Steuerelektronik (48), insbesondere eine zweite bestückte Platine, wobei der Gaskühlkanal (24) insbesondere zwischen der ersten Steuerelektronik (42) und der zweiten Steuerelektronik (48) angeordnet ist.

3. Elektronisches Steuergerät (20) nach Anspruch 1 oder Anspruch 2, wobei:
das elektronische Steuergerät (20) ferner ein Gehäuse (22) aufweist und die erste Steuerelektronik (42), die zweite Steuerelektronik (48) und/oder der Gaskühlkanal (24) in dem Gehäuse (22) angeordnet ist; und/oder
der Gaskühlkanal (24) in einer Kühlplatte oder Kühlschlange integriert ist, die mit der ersten Steuerelektronik (42), der zweiten Steuerelektronik (48) und/oder einem Gehäuse (22) des elektronischen Steuergeräts (20) zusammenmontiert ist.

4. Elektronisches Steuergerät (20) nach einem der vorherigen Ansprüche, wobei die erste Steuerelektronik (42) und/oder die zweite Steuerelektronik (48) ein Leistungsbauteil (36, 38, 40, 52, 54, 56), insbesondere einen Prozessor, einen Grafikprozessor, eine Netzwerkschnittstelle, einen Mikrocontroller und/oder eine Speichereinheit, aufweist, wobei das Leistungsbauteil (36, 38, 40, 52, 54, 56) wärmeleitend mit dem Gaskühlkanal (24), insbesondere dem Entspannungsabschnitt (24A) und/oder einem Abschnitt stromabwärts des Entspannungsabschnitts (24A), verbunden ist.

5. Elektronisches Steuergerät (20) nach einem der vorherigen Ansprüche, wobei:
der Gaskühlkanal (24) auf die erste Steuerelektronik (42) aufgesetzt ist und/oder die zweite Steuerelektronik (48) auf den Gaskühlkanal (24) aufgesetzt ist; und/oder
die erste Steuerelektronik (42) und/oder die zweite Steuerelektronik (48) eine Leiterplatte (44, 50) aufweist, wobei die Leiterplatte (44, 50) auf einer Seite, die dem Gaskühlkanal (24) zugewandt ist, mit dem Leistungsbauteil (36, 38, 40, 52, 54, 56) bestückt ist.

6. Elektronisches Steuergerät (20) nach einem der vorherigen Ansprüche, wobei der Gaskühlkanal (24) zum Führen von Druckluft ausgebildet ist und/oder mit einem Drucktank (16), insbesondere einem Drucklufttank, verbunden oder verbindbar ist.

7. Elektronisches Steuergerät (20) nach einem der vorherigen Ansprüche, ferner aufweisend einen Kühlkörper (30, 32, 34), der in dem Gaskühlkanal (24), insbesondere in dem Entspannungsabschnitt (24A) und/oder einem Abschnitt stromabwärts des Entspannungsabschnitts (24A), angeordnet und wärmeleitend mit der ersten Steuerelektronik (42) und/oder der zweiten Steuerelektronik (48) verbunden ist.

8. Elektronisches Steuergerät (20) nach Anspruch 7, wobei:
der Kühlkörper (30, 32, 34) wärmeleitend mit dem Leistungsbauteil (36, 38, 40, 52, 54, 56) der ersten Steuerelektronik (42) und/oder der zweiten Steuerelektronik (48) verbunden ist; und/oder
der Kühlkörper (30, 32, 34) eine Mehrzahl von Kühlrippen, die insbesondere entlang einer Strömungsrichtung im Gaskühlkanal (24) ausgerichtet sind, aufweist.

9. Elektronisches Steuergerät (20) nach einem der vorherigen Ansprüche, wobei eine Mehrzahl von Kühlkörpern (30, 32, 34) für die erste Steuerelektronik (42) und/oder die zweite Steuerelektronik (48), insbesondere für eine Mehrzahl von Leistungsbauteilen (36, 38, 40, 52, 54, 56) der ersten Steuerelektronik (42) und/oder der zweiten Steuerelektronik (48), vorgesehen ist.

10. Elektronisches Steuergerät (20) nach einem der vorherigen Ansprüche, wobei der Gaskühlkanal (24) eine Mehrzahl von Entspannungsabschnitten (24A) aufweist, die insbesondere jeweils wärmeleitend mit einem oder mehreren Leistungsbauteilen (36, 38, 40, 52, 54, 56) der ersten Steuerelektronik (42) und/oder der zweiten Steuerelektronik (48) verbunden sind und vorzugsweise in Reihe und/oder parallel angeordnet sind.

11. Elektronisches Steuergerät (20) nach einem der vorherigen Ansprüche, ferner aufweisend ein Gasventil (18), das im Gaskühlkanal (24), insbesondere stromaufwärts des Entspannungsabschnitts (24A), oder stromaufwärts des Gaskühlkanals (24) zum Einstellen einer Strömungsmenge des verdichteten Gases angeordnet ist.

12. Elektronisches Steuergerät (20) nach einem der vorherigen Ansprüche, wobei das elektronische Steuergerät (20) ferner einen Temperatursensor (46) zum Messen einer Temperatur des Leistungsbauteils (36, 38, 40, 52, 54, 56), der ersten Steuerelektronik (42), der zweiten Steuerelektronik (48) und/oder des elektronischen Steuergeräts (20) aufweist, wobei vorzugsweise das Gasventil (18) basierend auf einer von dem Temperatursensor (46) gemessen Temperatur gesteuert wird.

13. Kraftfahrzeug, insbesondere Nutzfahrzeug, mit einem Drucktank (16), vorzugsweise einem Drucklufttank, und einem elektronischen Steuergerät (20) nach einem der vorherigen Ansprüche, wobei der Gaskühlkanal (24) des elektronischen Steuergeräts (20) mit dem Drucktank (16) verbunden ist, wobei das Kraftfahrzeug insbesondere aufweist:
einen Motor (12); und
einen Verdichter (14), der von dem Motor (12) angetrieben wird und mit dem Drucktank (16) verbunden ist.

14. Verfahren zum Kühlen eines elektronischen Steuergeräts (20) in einem Kraftfahrzeug, aufweisend:
Führen eines verdichteten Gases, insbesondere Druckluft, durch einen Gaskühlkanal (24), der das verdichtete Gas von einer Steuerelektronik (42, 48) des elektronischen Steuergeräts (20) trennt und wärmeleitend mit der Steuerelektronik (42, 48) verbunden ist;
**gekennzeichnet durch**:
Entspannen des verdichteten Gases in dem Gaskühlkanal (24);
Abkühlen des Gases durch das Entspannen; und
Kühlen der Steuerelektronik (42, 48), insbesondere eines Leistungsbauteils (36, 38, 40, 52, 54, 56) der Steuerelektronik (42 48), durch das Abkühlen des Gases.

15. Verfahren nach Anspruch 14, ferner aufweisend:
Verdichten des Gases; und
Abkühlen des verdichteten Gases in einem Drucktank (16), insbesondere einem Drucklufttank, des Kraftfahrzeugs.

## Claims

1. Electronic control unit (20) for a motor vehicle, having:
a first electronic control device (42), in particular a first equipped circuit board; and
a gas cooling duct (24) for conducting a compressed gas, wherein the gas cooling duct (24);
is connected in a thermally conductive fashion to the first electronic control device (42), and
is designed to separate the compressed gas from the first electronic control device (42),
**characterized in that**
the gas cooling duct (24) has an expansion section (24A) in which a flow cross section of the gas cooling duct (24) widens in order to expand and cool the compressed gas in order to cool the first electronic control device (42).

2. Electronic control unit (20) according to Claim 1, also having a second electronic control device (48), in particular a second equipped circuit board, wherein the gas cooling duct (24) is arranged, in particular, between the first electronic control device (42) and the second electronic control device (48).

3. Electronic control unit (20) according to Claim 1 or Claim 2, wherein:
the electronic control unit (20) also has a housing (22), and the first electronic control device (42), the second electronic control device (48) and/or the gas cooling duct (24) are/is arranged in the housing (22); and/or
the gas cooling duct (24) is integrated into a cooling plate or cooling coil which is mounted together with the first electronic control device (42), the second electronic control device (48) and/or a housing (22) of the electronic control unit (20).

4. Electronic control unit (20) according to one of the preceding claims, wherein the first electronic control device (42) and/or the second electronic control device (48) have/has a power component (36, 38, 40, 52, 54, 56), in particular a processor, a graphic processor, a network interface, a microcontroller and/or a memory unit, wherein the power component (36, 38, 40, 52, 54, 56) is connected in a thermally conductive fashion to the gas cooling duct (24), in particular the expansion section (24A) and/or a section downstream of the expansion section (24A).

5. Electronic control unit (20) according to one of the preceding claims, wherein:
the gas cooling duct (24) is fitted onto the first electronic control device (42), and/or the second electronic control device (48) is fitted onto the gas cooling duct (24); and/or
the first electronic control device (42) and/or the second electronic control device (48) have/has a printed circuit board (44, 50), wherein the printed circuit board (44, 50) is equipped with the power component (36, 38, 40, 52, 54, 56) on a side which faces the gas cooling duct (24).

6. Electronic control unit (20) according to one of the preceding claims, wherein the gas cooling duct (24) is designed to conduct compressed air and/or is or can be connected to a pressure tank (16), in particular a compressed air tank.

7. Electronic control unit (20) according to one of the preceding claims, also having a heat sink (30, 32, 34) which is arranged in the gas cooling duct (24), in particular in the expansion section (24A) and/or in a section downstream of the expansion section (24A) and is connected in a thermally conductive fashion to the first electronic control device (42) and/or the second electronic control device (48).

8. Electronic control unit (20) according to Claim 7, wherein:
the heat sink (30, 32, 34) is connected in a thermally conductive fashion to the power component (36, 38, 40, 52, 54, 56) of the first electronic control device (42) and/or of the second electronic control device (48); and/or
the heat sink (30, 32, 34) has a multiplicity of cooling fins which are oriented, in particular, along a direction of flow in the gas cooling duct (24).

9. Electronic control unit (20) according to one of the preceding claims, wherein a multiplicity of heat sinks (30, 32, 34) are provided for the first electronic control device (42) and/or for the second electronic control device (48), in particular for a multiplicity of power components (36, 38, 40, 52, 54, 56) of the first electronic control device (42) and/or of the second electronic control device (48).

10. Electronic control unit (20) according to one of the preceding claims, wherein the gas cooling duct (24) has a multiplicity of expansion sections, (24A) which are each connected, in particular, in a thermally conductive fashion to one or more power components (36, 38, 40, 52, 54, 56) of the first electronic control device (42) and/or of the second electronic control device (48) and are preferably arranged in series and/or in parallel.

11. Electronic control unit (20) according to one of the preceding claims, also having a gas valve (18) which is arranged in the gas cooling duct (24), in particular upstream of the expansion section (24A), or upstream of the gas cooling duct (24) for setting a flow rate of the compressed gas.

12. Electronic control unit (20) according to one of the preceding claims, wherein the electronic control unit (20) also has a temperature sensor (46) for measuring a temperature of the power component (36, 38, 40, 52, 54, 56), of the first electronic control device (42), of the second electronic control device (48) and/or of the electronic control unit (20), wherein the gas valve (18) is preferably controlled on the basis of a temperature which is measured by the temperature sensor (46).

13. Motor vehicle, in particular utility vehicle, having a pressure tank (16), preferably a compressed air tank, and an electronic control unit (20) according to one of the preceding claims, wherein the gas cooling duct (24) of the electronic control unit (20) is connected to the pressure tank (16), wherein the motor vehicle has, in particular:
a motor (12); and
a compressor (14) which is driven by the motor (12) and is connected to the pressure tank (16).

14. Method for cooling an electronic control unit (20) in a motor vehicle, comprising:
conducting a compressed gas, in particular compressed air, through a gas cooling duct (24) which separates the compressed gas from an electronic control device (42, 48) of the electronic control unit (20) and is connected in a thermally conductive fashion to the electronic control device (42, 48);
**characterized by**:
expanding the compressed gas in the gas cooling duct (24) ;
cooling the gas by means of the expansion; and
cooling the electronic control device (42, 48), in particular a power component (36, 38, 40, 52, 54, 56) of the electronic control device (42, 48), by cooling the gas.

15. Method according to Claim 14, also comprising:
compressing the gas; and
cooling the compressed gas in a pressure tank (16), in particular a compressed air tank, of the motor vehicle.

## Revendications

1. Unité de commande électronique (20) destinée à un véhicule automobile, ladite unité comprenant :
une première électronique de commande (42), notamment une première carte électronique équipée ; et
un conduit de refroidissement à gaz (24) destiné à guider un gaz comprimé, le conduit de refroidissement à gaz (24) :
étant relié à la première électronique de commande (42) de manière thermoconductrice et étant conçu pour séparer le gaz comprimé de la première électronique de commande (42),
**caractérisée en ce que**
le conduit de refroidissement à gaz (24) comporte une portion de détente (24A) dans laquelle une section transversale d'écoulement du conduit de refroidissement à gaz (24) se dilate pour détendre et refroidir le gaz comprimé afin de refroidir la première électronique de commande (42).

2. Unité de commande électronique (20) selon la revendication 1, comportant en outre une deuxième électronique de commande (48), notamment une deuxième carte électronique équipée, le conduit de refroidissement à gaz (24) étant disposé notamment entre la première électronique de commande (42) et la deuxième électronique de commande (48).

3. Unité de commande électronique (20) selon la revendication 1 ou la revendication 2 :
l'unité de commande électronique (20) comportant en outre un boîtier (22) et la première électronique de commande (42), la deuxième électronique de commande (48) et/ou le conduit de refroidissement à gaz (24) étant disposés dans le boîtier (22) ; et/ou
le conduit de refroidissement à gaz (24) étant intégré dans une plaque de refroidissement ou un serpentin de refroidissement qui sont montés conjointement avec la première électronique de commande (42), la deuxième électronique de commande (48) et/ou un boîtier (22) de l'unité de commande électronique (20) .

4. Unité de commande électronique (20) selon l'une des revendications précédentes, la première électronique de commande (42) et/ou la deuxième électronique de commande (48) comportant un composant de puissance (36, 38, 40, 52, 54, 56), en particulier un processeur, un processeur graphique, une interface réseau, un microcontrôleur et/ou un module de mémoire, le composant de puissance (36, 38, 40, 52, 54, 56) étant relié de manière thermoconductrice au conduit de refroidissement à gaz (24), notamment à la portion de détente (24A) et/ou à une portion en aval de la portion de détente (24A).

5. Unité de commande électronique (20) selon l'une des revendications précédentes :
le conduit de refroidissement à gaz (24) étant placé sur la première électronique de commande (42) et/ou la deuxième électronique de commande (48) étant placée sur le conduit de refroidissement à gaz (24) : et/ou
la première électronique de commande (42) et/ou la deuxième électronique de commande (48) comportant une carte de circuit imprimé (44, 50), la carte de circuit imprimé (44, 50) étant équipée du composant de puissance (36, 38, 40, 52, 54, 56) du côté qui est dirigé vers le conduit de refroidissement à gaz.

6. Unité de commande électronique (20) selon l'une des revendications précédentes, le conduit de refroidissement à gaz (24) étant conçu pour guider de l'air comprimé et/ou étant relié ou pouvant être relié à un réservoir sous pression (16), notamment un réservoir d'air comprimé.

7. Unité de commande électronique (20) selon l'une des revendications précédentes, comprenant en outre un dissipateur thermique (30, 32, 34) qui est disposé dans le conduit de refroidissement à gaz (24), notamment dans la portion de détente (24A) et/ou une portion en aval de la portion de détente (24A), et est relié de manière thermoconductrice à la première électronique de commande (42) et/ou à la deuxième électronique de commande (48).

8. Unité de commande électronique (20) selon la revendication 7 :
le dissipateur thermique (30, 32, 34) étant relié de manière thermoconductrice au composant de puissance (36, 38, 40, 52, 54, 56) de la première électronique de commande (42) et/ou de la deuxième électronique de commande (48) ; et/ou
le dissipateur thermique (30, 32, 34) comportant une pluralité de nervures de refroidissement qui sont orientées en particulier suivant une direction d'écoulement dans le conduit de refroidissement à gaz (24) .

9. Unité de commande électronique (20) selon l'une des revendications précédentes, une pluralité de dissipateurs thermiques (30, 32, 34) étant prévue pour la première électronique de commande (42) et/ou la deuxième électronique de commande (48), notamment pour une pluralité de composants de puissance (36, 38, 40, 52, 54, 56) de la première électronique de commande (42) et/ou de la deuxième électronique de commande (48) .

10. Unité de commande électronique (20) selon l'une des revendications précédentes, le conduit de refroidissement à gaz (24) comportant une pluralité de portions de détente (24A) qui sont notamment reliées chacune de manière thermoconductrice à un ou plusieurs composants de puissance (36, 38, 40, 52, 54, 56) de la première électronique de commande (42) et/ou de la deuxième électronique de commande (48) et qui sont disposées de préférence en série et/ou en parallèle.

11. Unité de commande électronique (20) selon l'une des revendications précédentes, comportant en outre une soupape à gaz (18) qui est disposée dans le conduit de refroidissement à gaz (24), notamment en amont de la portion de détente (24A), ou en amont de la portion du conduit de refroidissement à gaz (24), pour régler un débit du gaz comprimé.

12. Unité de commande électronique (20) selon l'une des revendications précédentes, l'unité de commande électronique (20) comportant en outre un capteur de température (46) destiné à mesurer une température du composant de puissance (36, 38, 40, 52, 54, 56), la première électronique de commande (42), la deuxième électronique de commande (48) et/ou l'unité de commande électronique (20), la soupape à gaz (18) étant de préférence commandée en fonction d'une température mesurée par le capteur de température (46).

13. Véhicule automobile, notamment véhicule utilitaire, comprenant un réservoir sous pression (16), de préférence un réservoir d'air comprimé, et une unité de commande électronique (20) selon l'une des revendications précédentes, le conduit de refroidissement à gaz (24) de l'unité de commande électronique (20) étant reliée au réservoir sous pression (16), le véhicule automobile comportant notamment :
un moteur (12) ; et
un compresseur (14) qui est entraîné par le moteur (12) et qui est relié au réservoir sous pression (16).

14. Procédé de refroidissement d'une unité de commande électronique (20) dans un véhicule automobile, ledit procédé comportant les opérations suivantes :
guider un gaz comprimé, en particulier de l'air comprimé, à travers un conduit de refroidissement à gaz (24) qui sépare le gaz comprimé de l'électronique de commande (42, 48) de l'unité de commande électronique (20) et qui est relié de manière thermoconductrice à l'électronique de commande (42, 48) ;
**caractérisé par** les opérations suivantes :
détendre le gaz comprimé dans le conduit de refroidissement à gaz (24) ;
refroidir le gaz par l'opération de détente ; et
refroidir l'électronique de commande (42, 48), notamment un composant de puissance (36, 38, 40, 52, 54, 56) de l'électronique de commande (42, 48), par l'opération de refroidissement du gaz.

15. Procédé selon la revendication 14, comportant en outre les opérations suivantes :
comprimer le gaz ; et
refroidir le gaz comprimé dans un réservoir sous pression (16), notamment un réservoir d'air comprimé, du véhicule automobile.
